# EUROPEAN PATENT APPLICATION

(11) **EP 4 432 560 A1**
(43) Date of publication of application: **18.09.2024**
(21) Application number: 23794901.1
(22) Date of filing: 27.03.2023
(51) Int. Cl.: H03F 3/213, H03F 1/02

(54) **POWER AMPLIFICATION DEVICE AND METHOD FOR CONTROLLING POWER AMPLIFICATION DEVICE**

(30) Priority: 28.04.2022 CN 202210459695
(71) Applicant: Suzhou Watech Electronics Co., Ltd., Suzhou, Jiangsu 215125 (CN)
(72) Inventor: LIU, Haoyu, Shanghai 200127 (CN); YANG, Mengsu, Shanghai 200127 (CN); LIN, Liang, Shanghai 200127 (CN)
(74) Representative: Michalski Hüttermann & Partner Patentanwälte mbB
(86) International application number: PCT/CN2023/084014
(87) International publication number: WO 2023/207466

(57) **Abstract**

The present application provides a method for controlling a power amplification device. The power amplification device comprises: a first amplification path, wherein the first amplification path comprises a first transistor (T1) and a second transistor (T2), and an output end of the first transistor (T1) is electrically connected to a control end of the second transistor (T2); and a second amplification path, wherein the second amplification path comprises a third transistor (T3) and a fourth transistor (T4), and an output end of the third transistor (T3) is electrically connected to a control end of the fourth transistor (T4). The method comprises: transmitting an input signal to the first amplification path and the second amplification path; and providing a first direct current bias voltage (VG1) and a second direct current bias voltage (VG2) to the control end of the third transistor (T3) and the control end of the fourth transistor (T4), respectively, wherein current conduction channels of the third transistor (T3) and the fourth transistor (T4) comprise the same material, and the first direct current bias voltage (VG1) is higher than the second direct current bias voltage (VG2), so that a conduction angle of the third transistor (T3) is greater than that of the fourth transistor (T4). This is beneficial to improve the nonlinearity of the output current, thereby improving the efficiency of the power amplification device.

## Description

This application claims priority to Chinese Patent Application No. CN202210459695.4, filed on April 28, 2022, the contents of which is incorporated herein by reference in its entirety.

### TECHNICAL FIELD

The present disclosure relates to the technical field of signal processing, more particularly to a power amplifier and a method for controlling the power amplifier.

### BACKGROUND

In the fields of electronics, communication, and other technical fields, it is often necessary to amplify the power signal, so various electronic devices have corresponding power amplifiers. The power amplifier generally comprises transistors and necessary peripheral circuits. The transistors and peripheral circuits are fabricated on a printed circuit board. The printed circuit board is combined with other components of the electronic device and mounted inside the housing of the electronic device. The transistors and the peripheral circuits often occupy a large area on the printed circuit board, which is not conducive to the miniaturization of electronic devices. Moreover, the conventional power amplifier still has possibilities to improve in terms of efficiency and gain linearity.

### SUMMARY

In view of this, the present disclosure provides a method of controlling a power amplifier and a power amplifier, with the intention of overcoming some or all of the aforementioned deficiencies and other possible deficiencies.

According to a first aspect of the present disclosure, a method for controlling a power amplifier is provided. The power amplifier comprises: a first amplification path comprising a first transistor and a second transistor, an output port of the first transistor being electrically connected to a control port of the second transistor; and a second amplification path comprising a third transistor and a fourth transistor, an output port of the third transistor being electrically connected to a control port of the fourth transistor. The method comprises: transmitting input signals to the first amplification path and the second amplification path and supplying a first DC bias voltage and a second DC bias voltage to a control port of the third transistor and the control port of the fourth transistor respectively, a current conduction trench of the third transistor and a current conduction trench of the fourth transistor being made of same material, the first DC bias voltage being higher than the second DC bias voltage.

In some embodiments, each of the third transistor and the fourth transistor comprises a silicon transistor, wherein the difference between the first DC bias voltage and the second DC bias voltage is not higher than 0.5 volts.

In some embodiments, the difference between the first DC bias voltage and the second DC bias voltage is greater than or equal to 0.1 volts and less than or equal to 0.3 volts.

In some embodiments, the first DC bias voltage is greater than or equal to 1.9 volts and less than or equal to 2.2 volts.

In some embodiments, each of the third transistor and the fourth transistor comprises a silicon transistor, wherein the second DC bias voltage is greater than 0 and less than or equal to 3 volts.

In some embodiments, the second DC bias voltage is greater than or equal to 1.8 volts and less than or equal to 2.2 volts.

In some embodiments, each of the first transistor, the third transistor, and the fourth transistor comprises a silicon transistor, and the second transistor comprises a gallium nitride transistor.

In some embodiments, the power amplifier comprises a power divider electrically connected to the first amplification path and the second amplification path, where transmitting the input signal to the first amplification path and the second amplification path comprises allocating the input signal to the first amplification path and the second amplification path by the power divider.

In some embodiments, the method further comprises: in response to a power of the input signal being greater than or equal to a power threshold, providing a third DC bias voltage and a fourth DC bias voltage to an output port of the third transistor and an output port of the fourth transistor respectively, and in response to the power of the input signal being less than the power threshold, stopping providing the third DC bias voltage and the fourth DC bias voltage to the output port of the third transistor and the output port of the fourth transistor.

According to another aspect of the present disclosure, a power amplifier is provided. The power amplifier comprises: a first amplification path comprising a first transistor and a second transistor, an output port of the first transistor being electrically connected to a control port of the second transistor, the first amplification path being configured to obtain a first amplifying signal based on an input signal, a second amplification path comprising a third transistor and a fourth transistor, the output port of the third transistor being electrically connected to a control port of the fourth transistor, a current conduction trench of the third transistor and a current conduction trench of the fourth transistor made of same material, the second amplification path being configured to obtain a second amplifying signal based on the input signal, and a first power supply circuit being configured to provide a first DC bias voltage and a second DC bias voltage to a control port of the third transistor and the control port of the fourth transistor respectively, the first DC bias voltage being higher than the second DC bias voltage.

In some embodiments, each of the first transistor, the third transistor, and the fourth transistor comprises a silicon transistor, and the second transistor comprises a gallium nitride transistor.

In some embodiments, the power amplifier comprises a first sub-package structure comprising the second transistor and the fourth transistor.

In some embodiments, the first sub-package structure further comprises the first power supply circuit.

In some embodiments, the power amplifier further comprises a second sub-package structure comprising the first transistor and the third transistor, and the power amplifier further comprises a carrier board for carrying the first sub-package structure and the second sub-package structure.

In some embodiments, the power amplifier comprises a package structure comprising a substrate, and a third sub-package structure located on the substrate, the third sub-package structure comprising the first transistor and the third transistor, the second transistor and the fourth transistor being attached to the substrate.

In some embodiments, the first amplification path further comprises a first inter-stage matching circuit electrically connected between the first transistor and the second transistor, and the second amplification path further comprises a second inter-stage matching circuit electrically connected between the third transistor and the fourth transistor. The power amplifier comprises a package structure comprising a substrate, a fourth sub-package structure located on the substrate, and a fifth sub-package structure located on the substrate, the fourth sub-package structure comprising the first transistor and the first inter-stage matching circuit, the fifth sub-package structure comprising the third transistor and the second inter-stage matching circuit, and the second transistor and the fourth transistor attached to the substrate.

In some embodiments, the first amplification path further comprises a first inter-stage matching circuit electrically connected between the first transistor and the second transistor, and the second amplification path further comprises a second inter-stage matching circuit electrically connected between the third transistor and the fourth transistor. The package structure comprises a substrate, a sixth sub-package structure located on the substrate, and a seventh sub-package structure located on the substrate, the sixth sub-package structure comprising the first transistor and the first inter-stage matching circuit, the seventh sub-package structure comprising the third transistor, the fourth transistor, and the second inter-stage matching circuit, and the second transistor attached to the substrate.

In some embodiments, the power amplifier further comprises an output combination network electrically connected to an output port of the second transistor and an output port of the fourth transistor respectively, to combine the first amplifying signal the second amplifying signal.

In some embodiments, the power amplifier further comprises a second power supply circuit comprising a power detector configured to detect a power of the input signal, a voltage regulation circuit configured to be electrically connected to the output port of the third transistor, and the output port of the fourth transistor to provide the third DC bias voltage and the fourth DC bias voltage to the output port of the third transistor and the output port of the fourth transistor respectively, and a controller electrically connected to the power detector and the voltage regulation circuit, and configured to, in response to the power of the input signal being less than the power threshold, disable the voltage regulation circuit, and in response to the power of the input signal being greater than or equal to the power threshold, enable the voltage regulation circuit.

With some embodiments of the present disclosure mentioned above, different embodiments can be further obtained based on a combination of some embodiments and a combination of features in different embodiments, which also fall within the scope of protection of the present disclosure.

These and other advantages of the present disclosure will become clear according to the embodiments described below, and these and other advantages of the present disclosure will be elucidated with reference to the embodiments described below.

### BRIEF DESCRIPTION OF THE DRAWINGS

The embodiments of the present disclosure will now be described in more detail and with reference to the drawings, where:
Fig. 1a is a schematic structural view of a power amplifier according to an embodiment of the present disclosure.
Fig. 1b is a method of controlling the power amplifier according to an embodiment of the present disclosure.
Fig. 2 is a schematic circuit diagram of the power amplifier according to another embodiment of the present disclosure.
Fig. 3 is an output current characteristic of the power amplifier shown in Fig. 2 being controlled by the comparative controlling method of the present disclosure.
Fig. 4 is an output current characteristic of the power amplifier shown in Fig. 2 being controlled by the controlling method in Fig. 1b of the present disclosure.
Fig. 5 is an efficiency characteristic of the power amplifier shown in Fig. 2 being controlled by the comparative controlling method and the controlling method in Fig. 1b of the present disclosure.
Figs. 6 and 7 are gain characteristics and AM-PM distortion characteristics of the power amplifier with different types of fourth transistors and different second DC bias voltages applied to the power amplifier of the present disclosure.
Fig. 8a is a schematic structural view of the power amplifier according to another embodiment of the present disclosure.
Fig. 8b is a schematic structural view of a second power supply circuit of the power amplifier according to another embodiment of the present disclosure.
Fig. 9 is a schematic structural view of a first sub-package structure of the power amplifier according to another embodiment of the present disclosure.
Fig. 10 is a schematic structural view of the power amplifier according to another embodiment of the present disclosure.
Fig. 11 is a schematic structural view of a package structure comprised by the power amplifier according to another embodiment of the present disclosure.
Fig. 12 is a schematic structural view of a package structure comprised by the power amplifier according to yet another embodiment of the present disclosure.
Fig. 13 is a schematic structural view of a package structure comprised by the power amplifier according to yet another embodiment of the present disclosure.

### DETAILED DESCRIPTION OF THE EMBODIMENTS

The following description provides specific details of various embodiments of the present disclosure so that one skilled in the art can fully understand and implement various embodiments of the present disclosure. In some cases, the present disclosure does not illustrate or describe in detail some structures or functions well known in the art, in order to avoid such unnecessary descriptions obscuring the description of embodiments of the present disclosure. The technical proposal of the present disclosure cab be embodied in many different forms and purposes and should not be limited to the embodiments described herein. These embodiments are provided in order to make the technical proposal of the present disclosure clear and complete, but the embodiments do not limit the scope of protection of the patent application.

Herein, part of the terms involved in the embodiments of the present disclosure will be explained first, so as to facilitate the understanding of those skilled in the art.

The "package structure" mentioned in the disclosure refers to a product formed by different components being fabricated on the same substrate through an integrated process and sealed in the same packaging shell. The package structure can be in the form of a chip. Likewise, the "sub-package structure" mentioned herein has characteristics similar to the above-mentioned package structure and can be in the form of a chip, but the "sub-package structure" is fabricated on the substrate of the above-mentioned package structure and is sealed inside the package structure, that is, the sub-package structure can be regarded as a component of the package structure.

The transistors mentioned herein are semiconductor devices with three ports comprising a gate, a source, and a drain, or a base, a collector, and an emitter. The control port of the transistor mentioned herein refers to the gate or the base, and the output port of the transistor refers to one of the source and the drain, or one of the collector and the emitter.

The "silicon transistor" mentioned herein refers to transistors having a current conduction trench mainly comprising silicon semiconductor materials. The silicon transistor comprises but is not limited to lateral double-diffused metal oxide semiconductor (LDMOS) transistors. The "gallium nitride transistors" refers to transistors having a current conduction trench mainly comprising gallium nitride semiconductor materials. The gallium nitride transistor comprises but is not limited to high electron mobility transistors (HEMT).

The "symmetry" mentioned herein is used to describe the similarity between two sub-circuits. The symmetry of two sub-circuits means that the two sub-circuits comprise electrical components of the same type, the number of electrical components of the same type in the two sub-circuits is the same, and the connection relationship between the various electrical components in the two sub-circuits is also the same. In other words, if factors such as the parameters of electrical components are not taken into account, the symmetry of the two sub-circuits means that the two sub-circuits have the same circuit structure.

The "grounded port" mentioned herein refers to the position having a reference ground potential in the package structure. The specific form of the grounded port comprises but are not limited to terminals, nodes or electrical connection wires.

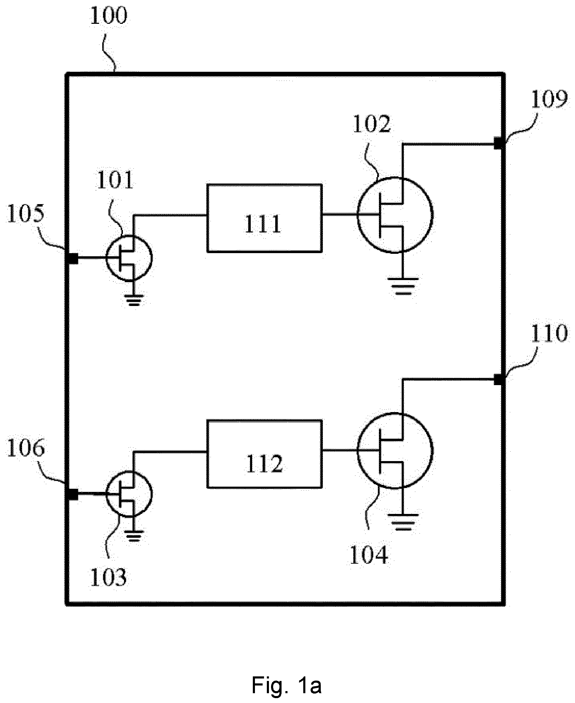

Fig. 1a schematically shows an exemplary topology of a power amplifier according to an embodiment of the present disclosure. As shown in Fig. 1a, the power amplifier 100 comprises a first amplification path and a second amplification path. The first amplification path comprises a first transistor 101 and a second crystal 102, and an output port of the first transistor 101 is electrically connected to a control port of the second transistor 102. The second amplification path comprises a third transistor 103 and a fourth transistor 104, an output port of the third transistor 103 being electrically connected to a control port of the fourth transistor 104. The current conduction trenches of the third transistor 103 and the fourth transistor 104 comprise the same material, for example, the current conduction trenches of the third transistor 103 and the fourth transistor 104 both comprise a silicon semiconductor material, i.e., the third transistor 103 and the fourth transistor 104 both are silicon transistors, or the current conduction trenches of the third transistor 103 and the fourth transistor 104 both comprise a gallium nitride semiconductor material. The third transistor 103 and the fourth transistor 104 both are gallium nitride transistors. The first transistor 101 or the second crystal 102 can be any one of a silicon transistor or a gallium nitride transistor. The first amplification path can receive an input signal from an input port 105 and generate a first amplifying signal from an output port 109, and the second amplification path can receive an input signal from an input port 106 and generate a second amplifying signal from an output port 110. It can be understood that the first amplification path can also comprise an inter-stage matching circuit 111 electrically connected between the first transistor and second transistor, and an inter-stage matching circuit 112 electrically connected between the third transistor and fourth transistor, to enable signal transmission and impedance matching on the first amplification path and second amplification path. The first amplification path and the second amplification path each comprise two transistors, and the gain of each amplification path is increased relative to the case where a single amplification path only comprises one single transistor, so that the amplification effect of the power amplifier on the input signal can be improved in general. However, the inventors of the present disclosure have found that the signal amplifier based on the power amplifier shown in Fig. 1a is still unsatisfactory in terms of efficiency and linearity.

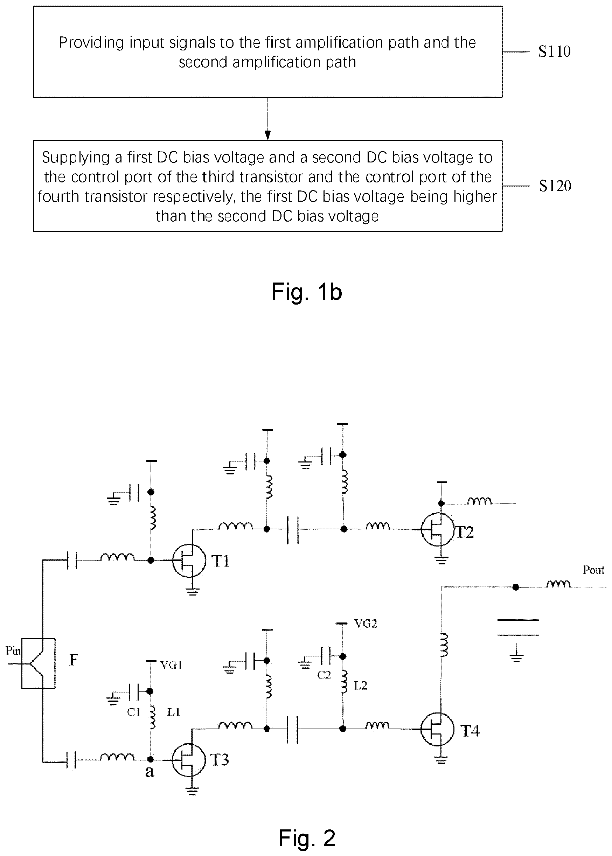

Fig. 1b illustrates a method of controlling the power amplifier according to the embodiment of the present disclosure to improve the efficiency of the power amplifier. As shown in Fig. 1b, the method comprises: S110, providing input signals to the first amplification path and the second amplification path, and S120, supplying a first DC bias voltage and a second DC bias voltage to the control port of the third transistor and the control port of the fourth transistor respectively, the first DC bias voltage being higher than the second DC bias voltage.

The first DC bias voltage and the second DC bias voltage mentioned herein refer to the DC voltage provided to the control ports of the third transistor and the fourth transistor to realize the amplification function. Further, the input signals provided to the first amplification path and the second amplification path originate from the same signal source. That is, the same input signal can be provided to the first amplification path and the second amplification path, or the input signals originating from the signal source can be provided to the first amplification path and the second amplification path respectively by additional signal processing. For example, the input signal can be power-allocated by a power divider to obtain two channels of signals, which are provided to the first amplification path and the second amplification path respectively.

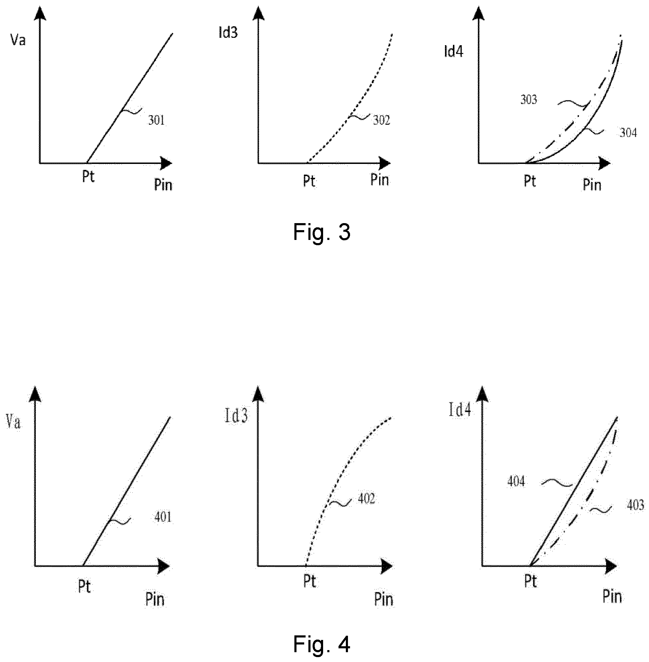

The method of controlling the power amplifier provided by the embodiment of the present disclosure will be further described below with reference to Fig. 2. Fig. 2 is a schematic circuit diagram of the power amplifier according to another embodiment of the present disclosure. As shown in Fig. 2, the power amplifier comprises a first transistor T1, a second transistor T2, a third transistor T3, and a third transistor T4 corresponding to the first transistor 101, the second transistor 102, the third transistor 103, and the third transistor 104 shown in Fig. 1 respectively. The output port (e.g., drain) of the first transistor T1 is electrically connected to the control port (e.g., gate) of the second transistor T2, the output port (e.g., drain) of the third transistor T3 is electrically connected to the control port (e.g., gate) of the fourth transistor T4, and the other ports (e.g., source) of each of the first transistor T1, the second transistorT2, the third transistorT3 and the third transistorT4 are grounded. The power amplifier shown in Fig. 1 further comprises a power divider F, and the input signal Pin is allocated to the first amplification path and the second amplification path. As shown in Fig. 2, the input matching circuits are provided between the power divider F and the control port of the first transistor T1, and between the power divider F and the third transistor T3. The inter-stage matching circuits are provided between the first transistor T1 and the second transistor T2, and between the third transistor T3 and the fourth transistorT4 respectively. The input matching circuit and the inter-stage matching circuit can comprise an inductor and a capacitor to realize transmission of the input signal on the first amplification path and the second amplification path and impedance matching on the signal transmission path. In the embodiment of Fig. 2, the first amplifying signal generated by the first amplification path and the second amplifying signal generated by the second amplification path are combined to form a combined power signal Pout, and the power amplifier is implemented as a Doherty amplifier. The first DC bias voltage and the second DC bias voltage mentioned in the above-described embodiment of the method for controlling the power amplifier are defined as VG1 and VG2 respectively, in Fig. 2. The inductor L1 and the capacitor C1 can regulate and filter the first DC bias voltage VG1, and the inductor L2 and the capacitor C2 can also regulate and filter the second DC bias voltage VG2. The capacitors C1 and C2 can also reduce or avoid the effect of the input signal (e.g., a radio frequency signal) transmitted on the second amplification path on the first DC bias voltage and the second DC bias voltage. As will be described below in Figs. 3 to 5, making the first DC bias voltage VG1 for the third transistor higher than the second DC bias voltage VG2 for the fourth transistor can increase the saturated output power and amplification efficiency of the power amplifier.

The method for controlling the power amplifier provided by the embodiment of the present disclosure is based on the following technical insight: in a case where the second amplifier path comprising the third transistor and the fourth transistor is running, the output current of the second amplifier path (the drain current at the drain of the fourth transistor) shows a relatively serious non-linearity, which adversely affects the overall output power and efficiency of the power amplifier. With the first DC bias voltage for the third transistor higher than the second DC bias voltage for the fourth transistor, the conduction angle of the third transistor is larger than the conduction angle of the fourth transistor, which is conducive to improving the non-linearity of the output current, thereby improving the efficiency of the power amplifier.

A comparative control method for a power amplifier is described below with reference to Fig. 2 to better understand the method of controlling a power amplifier provided by the above-described embodiment. The power amplifier shown in Fig. 2 can be implemented as a Doherty amplifier. In the comparative control method, the first DC bias voltage supplied on the third transistor T3 is the same as the second DC bias voltage supplied to the fourth transistorT4 shown in Fig. 2, or the third transistor and the fourth transistor are in the same operating mode. For example, when the third transistor and the fourth transistor are LDMOS transistors, the DC bias voltage supplied to the control port of the third transistor and the control port of the fourth transistor is 1.5 v, the conduction angle of the third transistor and the fourth transistor is approximately 150 degrees, and the third transistor and the fourth transistor are both operating in the C Class mode. Fig. 3 shows the curves of the voltage Va at the node a (i.e., the control port of the third transistor T3), the drain current Id3 of the third transistor T3, and the drain current Id4 of the fourth transistor T4 in Fig. 2 with the changing input power Pin respectively. As shown in Fig. 3, in a case where the power of the input signal Pin exceeds the power threshold Pt, the second amplification path comprising the third transistor T3 and the fourth transistor T4 starts to operate, and the voltage Va at the node a also increases with the increasing input power, as shown in 301 in Fig. 3. It can be understood that the node voltage Va mentioned herein is different from the first DC bias voltage VG1. The node voltage Va reflects the voltage amplitude of the input signal (e.g., the radio frequency signal) and varies with the change of the input signal, and the first DC bias voltage VG1 is a relatively constant DC voltage for turning on the third transistor T3. In the case where the comparative control method is applied, the drain current Id3 of the third transistor and the drain current Id4 of the fourth transistor are shown in curves 302 and 304 in Fig. 3 respectively. In Fig. 3 and Fig. 4 to be described below, the drain current refers to the current amplitude of the input signal (e.g., a radio frequency signal) transmitted by the third transistor or the fourth transistor. The curve 303 shown in Fig. 3 represents the drain current of the fourth transistor in the absence of the third transistor T3 (i.e., the second amplification path only comprises the fourth transistor T4). As can be seen from Fig. 3, the drain current Id4 of the second amplification path has severe nonlinearity, which adversely affects the efficiency of the Doherty amplifier.

As can be understood from the specific example below, the first DC bias voltage for the third transistor is higher than the second DC bias voltage for the fourth transistor, so that the third transistor in the second amplification path has a large conduction angle, the output current (e.g., drain current) of the third transistor can have strong expandability, and the linearity of the current at the output port of the fourth transistor cascaded with the third transistor can be improved. The improvement of the linearity of the output current of the fourth transistor is conducive to improving the overall efficiency of the power amplifier.

In some embodiments, each of the third transistor and the fourth transistor comprises a silicon transistor, and the difference between the first DC bias voltage and the second DC bias voltage is not higher than 0.5 volts. Based on the current technology level of making transistors, the DC bias voltage for turning on by the silicon transistor is generally not more than 3 volts, and the first DC bias voltage is slightly larger than the second DC bias voltage to achieve a larger conduction angle of the third transistor, thereby improving the linearity of the output current of the second amplification path. In some embodiments, the difference between the first DC bias voltage and the second DC bias voltage is greater than or equal to 0.1 volts and less than or equal to 0.3 volts. For example, the third transistor and the fourth transistor both comprise LDMOS transistors, the first DC bias voltage is greater than or equal to 1.9 volts and less than or equal to 2.2 volts (e.g., VG1 is 1.9 volts), and the second DC bias voltage is greater than or equal to 1.8 volts and less than or equal to 2.2 volts (e.g., VG2 is 1.8 volts). In the case, the third transistor can have a conduction angle of 160 degrees to 170 degrees, and the fourth transistor can have a conduction angle of approximately 150 degrees, which can achieve a better effect of improving the non-linearity of the output current of the second amplification path.

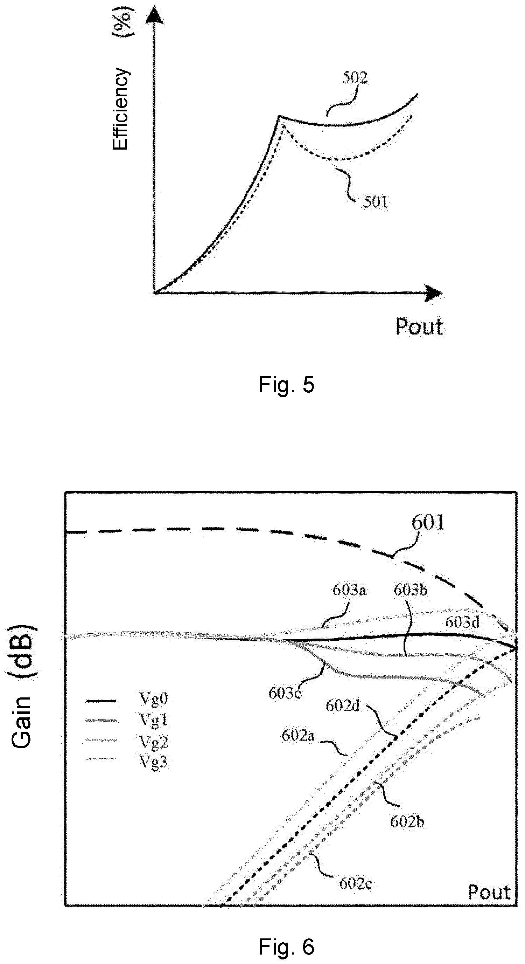

Fig. 4 shows changes in the node voltage Va, the drain current Id3 of the third transistor, and the drain current Id4 of the fourth transistor with the input signal Pin, in a case where the power amplifier shown in Fig. 2 is controlled by the method shown in Fig. 1b of the present disclosure. In the case, the first DC bias voltage VG1 is 1.9 volts and the second DC bias voltage VG2 is 1.8 volts. As can be seen from Fig. 4, the changing trend 401 of the node voltage Va is substantially consistent with the node voltage Va in Fig. 3, but the changing curve 402 of the drain current Id3 of the third transistor has expandability compared with the changing curve 302 of the drain current Id3 in Fig. 3, and the changing curve 404 of the drain current of the fourth transistor has a good linearity. The curve 403 shown in Fig. 4 is consistent with the meaning of the curve 303 in Fig. 3, that is, the drain current of the fourth transistor in the absence of the third transistor T3 (i.e., the second amplification path only comprises the fourth transistor T4). Fig. 5 shows the efficiency curves of the power amplifier shown in Fig. 2 respectively applied with the comparative control method and the control method shown in Fig. 2. The "efficiency" referred to herein refers to the ratio of the output power of the output signal of the power amplifier to the total DC power consumed by the power amplifier. The curve 501 in Fig. 5 corresponds to the efficiency characteristic of the power amplifier shown in Fig. 2 applied with the comparative control method, and the curve 502 corresponds to the efficiency characteristic of the power amplifier shown in Fig. 2 applied with the control method as shown in Fig. 3.

According to further embodiments of the present disclosure, the third transistor and the fourth transistor each comprise a gallium nitride transistor, the DC bias voltage applied to the control port of the gallium nitride transistor for turning on is between -5 volts and -2 volts based on the current level of the process. In the case, the first DC bias voltage is between -2.8 volts and -3.5 volts, and the second DC bias voltage is between -3.5 volts and -4.5 volts, so that the conduction angle of the third transistor is larger than that of the fourth transistor, and the efficiency of the power amplifier is improved.

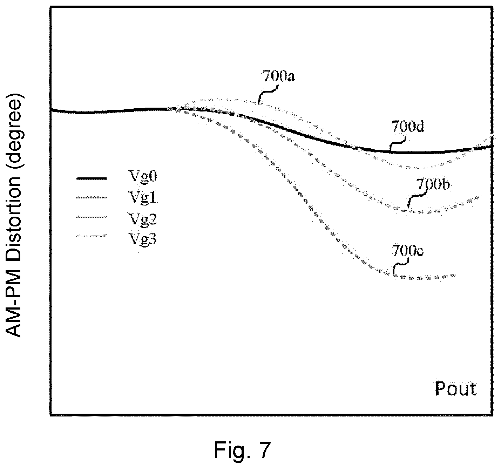

In addition, the inventors of the present disclosure have acquired the following technical knowledge in the technical research practice: the specific type of the fourth transistor and the second DC bias voltage provided to the fourth transistor have a significant impact on the gain and phase characteristics of the power amplifier. In other words, with a different type of fourth transistor and changing the voltage of the second DC bias voltage supplied to the fourth transistor can result in a significant change in the gain and phase characteristics of the power amplifier. Fig. 6 shows the gain characteristics of different types of fourth transistors applied with different second DC bias voltages according to the power amplifier shown in Fig. 2. The curve 601 in Fig. 6 shows the gain of the first amplification path in the power amplifier shown in Fig. 2 as a function of the output power. The curves 602a-602d show the gain of the second amplification path in the power amplifier shown in Fig. 2 as a function of the output power. The curves 603a-603d show the overall gain of the power amplifier shown in Fig. 2 as a function of the output power. As shown in Fig. 6, the curves 602a and 603a respectively correspond to the gain of the second amplification path and the gain of the power amplifier in a case where the fourth transistor is a silicon transistor and the second DC bias voltage is Vg3, the curves 602b and 603b respectively correspond to the gain of the second amplification path and the gain of the power amplifier in a case where the fourth transistor is a silicon transistor and the second DC bias voltage is Vg2, the curves 602c and 603c respectively correspond to the gain of the second amplification path and the gain of the power amplifier in a case where the fourth transistor is a gallium nitride transistor and the second DC bias voltage is Vg1, and the curves 602d and 603d respectively correspond to the gain of the second amplification path and the gain of the power amplifier in a case where the fourth transistor is a silicon transistor and the second DC bias voltage is Vg0. The curves 700a, 700b, 700c, and 700d in Fig. 7 showAM-PM distortion characteristics in a case where different types of fourth transistors are employed and different second DC bias voltages Vg0, Vg1, Vg2, and Vg3 are applied to the power amplifier shown in Fig. 2. Specifically, the curve 700c corresponds to the AM-PM distortion characteristic in a case where the fourth transistor is a gallium nitride transistor and the second DC bias voltage is Vg1, and the curve 700a, 700b, and 700d respectively correspond to the AM-PM distortion characteristic in a case where the fourth transistor is a silicon transistor and the second DC bias voltage is Vg3, Vg2, and Vg0. The second DC bias voltage Vg1 is between -6 volts and -3 volts, and in the embodiment of Figs. 6 and 7, Vg1 is -4.2 volts. The gain compression of the power amplifier is large (the gain characteristic curve is uneven), and there is also a large phase distortion. The second DC bias voltage Vg2 is greater than 0 volts and less than 1.8 volts. In the embodiment of Figs. 6 and 7, Vg2 is 1.5 volts, and the overall gain and phase distortion of the power amplifier are improved. The second DC bias voltage Vg3 is greater than or equal to 2.2 volts and less than or equal to 3 volts. In the embodiment of Figs. 6 and 7, Vg3 is 2.5 volts, the gain of the second amplification path is too large, resulting in large fluctuations in the overall gain and phase distortion of the power amplifier. The second DC bias voltage Vg0 is greater than or equal to 1.8 volts and less than or equal to 2.2 volts. In the embodiment of Figs. 6 and 7, Vg0 is 1.8 volts, the gain characteristic curve 603d has good flatness, and the phase characteristic curve 700d has a low degree of distortion (less than 15 degrees). Accordingly, according to embodiments of the present disclosure, both the third transistor and the fourth transistor can comprise silicon transistors, and the second DC bias voltage is greater than or equal to 1.8 volts and less than or equal to 2.2 volts, so that the power amplifier achieves good gain characteristics and phase distortion characteristics.

In the other embodiments of the present disclosure, each of the first transistor, the third transistor, and the fourth transistor comprises a silicon transistor, and the second transistor comprises a gallium nitride transistor. The fabrication cost of the gallium nitride transistor is relatively higher than the silicon transistor, but it has a higher amplification efficiency. Therefore, the second transistor in the first amplification path comprises the gallium nitride transistor, which is conducive to improving the overall efficiency of the power amplifier, and will not lead to a substantial increase in the cost of the power amplifier.

In the other embodiments of the present disclosure, the method for controlling the power amplifier further comprises: in response to the power of the input signal being greater than or equal to a power threshold, providing a third DC bias voltage and a fourth DC bias voltage to an output port of the third transistor and an output port of the fourth transistor respectively, and in response to the power of the input signal being less than the power threshold, stopping providing the third DC bias voltage and the fourth DC bias voltage to the output port of the third transistor and the output port of the fourth transistor. The "third DC bias voltage" and "fourth DC bias voltage" mentioned herein refer to the DC voltage that the third transistor and the fourth transistor need to provide to the output port (e.g., drain) to realize the amplification function respectively. In the embodiment, in a case where the power of the input signal reaches or exceeds the power threshold, the output port of the third transistor and the output port of the fourth transistor are provided with the third DC bias voltage and the fourth DC bias voltage respectively, to realize the signal amplification function of the second amplification path. In a case where the power of the input signal is less than the power threshold, the output ports of the third transistor and the fourth transistor are in a state of stopping operation because the corresponding DC bias voltage is not received, and only the first amplification path is in a state of operation. Therefore, the power amplifier can realize power output ports of different values, expand the scenarios of the power amplifier, and improve the application flexibility of the power amplifier. Further, additional power loss caused by the third transistor, the fourth transistor, and the circuit providing the third DC bias voltage and the fourth DC bias voltage can be reduced or avoided.

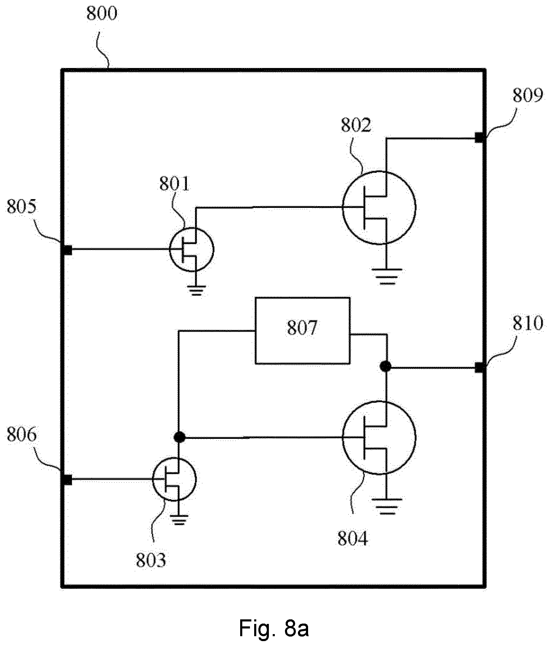

According to another aspect of the present disclosure, a power amplifier is provided. As shown in Fig. 8a, the power amplifier 800 comprises a first amplification path configured to provide a first amplifying signal based on an input signal, the first amplification path comprising a first transistor 801 and a second transistor 802, a second amplification path configured to provide a second amplifying signal based on the input signal, the second amplification path comprising a third transistor 803 and a fourth transistor 804, and a first power supply circuit (not shown). An output port of the first transistor 801 is electrically connected to the control port of the second transistor 802, and an output port of the third transistor 803 is electrically connected to the control port of the fourth transistor 804. The first power supply circuit is configured to provide a first DC bias voltage and a second DC bias voltage to the control port of the third transistor and the control port of the fourth transistor respectively. The current conduction trenches of the third transistor and the fourth transistor comprise the same material. The first DC bias voltage is higher than the second DC bias voltage. The power amplifier shown in Fig. 8a schematically represents the main topology, and for the sake of brevity, the inter-stage matching circuits between the first transistor and the second transistor, and between the third transistor and the fourth transistor, and other necessary peripheral circuits are not shown. The "first power supply circuit" referred to herein comprises a circuit providing a first DC bias voltage and a second DC bias voltage to the control ports of the third transistor and the fourth transistor. For example, the circuit is provided for providing the first DC bias voltage VG1 and the second DC bias voltage VG2 as shown in Fig. 2. Specific forms of the power supply circuit are not limited herein. For example, the first power supply circuit can take the form of one single circuit unit, in which case the first power supply circuit can be regarded as the circuit unit capable of providing at least two DC output voltages. Alternatively, the first power supply circuit can comprise a plurality of circuit units, the first DC bias voltage and the second DC bias voltage being provided by different circuit units respectively. The first power supply circuit can comprise a DC-DC conversion circuit, that is, the first power supply circuit obtains the first DC bias voltage or the second DC bias voltage based on an existing DC voltage, for example, the first power supply circuit can be implemented as a boost or buck chopper, or the first power supply circuit can be implemented as a DC voltage divider. Further, the first power supply circuit can also comprise a rectifying circuit or the like, that is, in the case, the first power supply circuit obtains the first DC bias voltage or the second DC bias voltage based on an AC voltage, and the present disclosure does not specifically limit embodiments of the first power supply circuit. For the power amplifier shown in Fig. 8a, the first DC bias voltage is higher than the second DC bias voltage provided by the first power supply circuit. The embodiment shown in Fig. 8a can achieve a technical effect similar to the embodiment of the method for controlling the power amplifier described above, which will not be described here in detail.

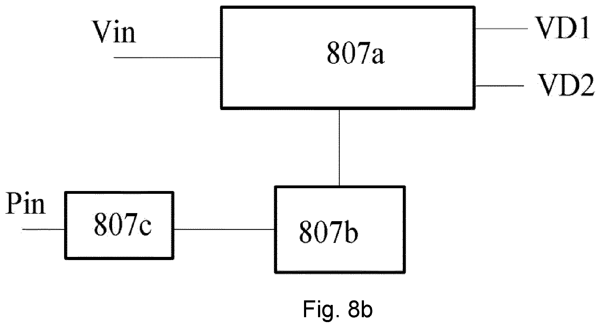

In other embodiments of the present disclosure, the power amplifier further comprises a second power supply circuit comprising a power detector configured to detect a power of the input signal, a voltage regulation circuit configured to be electrically connected to the output port of the third transistor and the output port of the fourth transistor to provide the third DC bias voltage and the fourth DC bias voltage to the output port of the third transistor and the output port of the fourth transistor respectively, and a controller electrically connected to the power detector and the voltage regulation circuit, and configured to, in response to the power of the input signal being less than the power threshold, disable the voltage regulation circuit, and in response to the power of the input signal being greater than or equal to the power threshold, enable the voltage regulation circuit. The second power supply circuit is defined as 807 in Fig. 8a. Fig. 8b shows an exemplary configuration of the second power supply circuit. As shown in Fig. 8b, the second power supply circuit comprises a power detector 807c configured to detect the power of the input signal Pin, a voltage regulation circuit 807a configured to be electrically connected to the output port of the third transistor, and the output port of the fourth transistor to provide a third DC bias voltage VD1 and a fourth DC bias voltage VD2 to the output port of the third transistor and the output port of the fourth transistor respectively, and a controller 807b electrically connected to the power detector 807c and the voltage regulation circuit 807a and configured to disable the voltage regulation circuit 807a in response to the power of the input signal Pin being less than a power threshold, and enable the voltage regulation circuit 807a in response to the power of the input signal Pin being greater than or equal to the power threshold. The voltage regulation circuit 807a can be implemented in the form of a DC-DC converter, comprising but not limited to, a step-down chopper, a step-up chopper, a step-up chopper, and the like. The voltage regulation circuit 807a receives the DC voltage Vin to generate the third DC bias voltage VD1 and the fourth DC bias voltage VD2. The voltage regulation circuit 807a can comprise two DC-DC converters that generate the third DC bias voltage and the fourth DC bias voltage respectively. Alternatively, the voltage regulation circuit 807a can also comprise only a DC-DC converter generating a third DC bias voltage and a voltage dividing circuit connected to an output port of the DC-DC converter. The voltage dividing circuit can generate the fourth DC bias voltage based on the third DC bias voltage. In another embodiment, the voltage regulation circuit 807a can comprise a rectifying circuit, and the voltage regulation circuit 807a receives the AC voltage Vin to generate the third DC bias voltage and the fourth DC bias voltage. The controller 807b can generate signals that control the voltage regulation circuit 807a, for example, the controller 807b is a PWM controller to provide a PWM modulation signal to a control port of a power switch in the DC-DC converter of the voltage regulation circuit 807a to generate the desired third DC bias voltage and the desired fourth DC bias voltage. The power detector 807c can detect the power of the input signal Pin by sensing the voltage and current of the input signal. The controller 807b is electrically connected to the power detector 807c and receives the power detected by the power detector 807c in real-time, and disables the voltage regulation circuit 807a in a case where the power of the input signal Pin is lower than the power threshold. For example, the controller 807b outputs a signal to the control port of the power switch in the DC-DC converter of the voltage regulation circuit 807a such that the power switch is continuously turned off, so that the voltage regulation circuit 807a does not output the DC voltage. In a case where the power of the input signal Pin reaches the power threshold, the controller 807b outputs a normal PWM pulse signal to the control port of the power switch in the DC-DC converter of the voltage regulation circuit 807a to enable the voltage regulation circuit 807a. Thus, in a case where the power of the input signal Pin is lower than the power threshold, the voltage regulation circuit can be actively disabled, and the third transistor and the fourth transistor can be stopped accordingly, thereby facilitating the reduction of energy consumption generated by the power amplifier.

Further, in some embodiments, each of the first transistor, the third transistor, and the fourth transistor in the power amplifier comprises a silicon transistor, and the second transistor in the power amplifier comprises a gallium nitride transistor.

The power amplifier provided by embodiments of the present disclosure can be implemented in different physical forms, and in some embodiments, the power amplifier comprises a first sub-package structure comprising a second transistor 802 and a fourth transistor 804. That is, the second transistor 802 and the fourth transistor 804 can be implemented in the form of one single chip. Thus, the integration level of the components of the power amplifier is improved, and the size of the power amplifier is advantageous to be reduced. Further, according to some embodiments of the present disclosure, the first sub-package structure comprises a power supply circuit 807 to further improve the integration of the power amplifier.

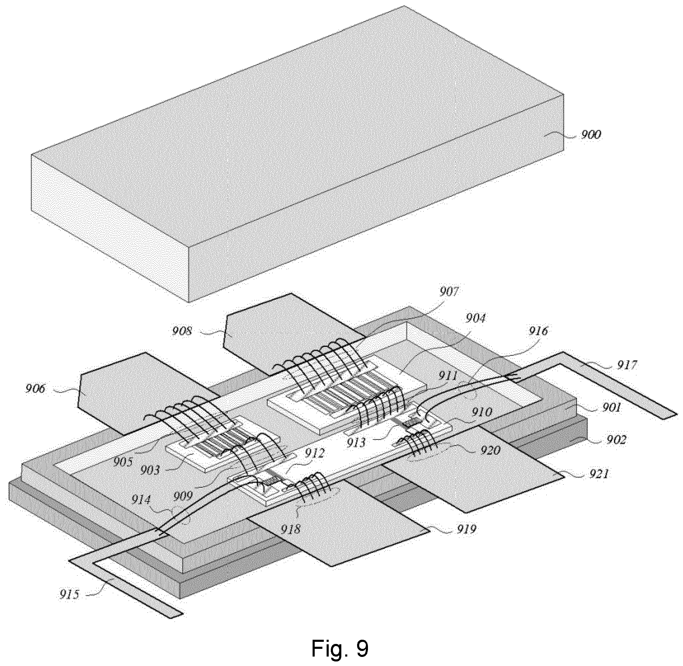

Fig. 9 shows the first sub-package structure according to the embodiment of the present disclosure. As shown in Fig. 9, the first sub-package structure comprises: a cavity cover plate 900 (the material thereof can be metal, ceramic, plastic, etc.), the cavity cover plate 900 can protect the components in the cavity of the sub-package structure and being a sealing and electromagnetic shield, a cavity peripheral material 901 (the material thereof can be ceramic, plastic, etc.), a substrate 902 (the material thereof can be diamond, metal, etc.), where the substrate 902 can carry the components in the first sub-package and provide heat dissipation and grounded circuits, a second transistor 903 (gallium nitride transistor) electrically connected to a output node 906 of the first sub-package structure via a bonding wire 905, and is electrically connected to a gate bias circuit 910 via a bonding wire 909, a fourth transistor 904 (silicon transistor) electrically connected to an output node 908 of the first sub-package structure via a bonding wire 907 and electrically connected to the gate bias circuit 910 via a bonding wire 911, and the gate bias circuit 910 is electrically connected to the input nodes 919, 921 of the first sub-package structure via bonding wires 918 and 920 respectively. The gate bias circuit comprises a first circuit unit 912 and a second circuit unit 913 respectively providing corresponding DC bias voltages to the control port (e.g., gate) of the second transistor 903 and the control port (e.g., gate) of the fourth transistor 904. In the embodiment shown in Fig. 9, the entirety of the gate bias circuit 910 can be regarded as another power supply circuit supplying the DC voltage to the control port of the second transistor and the control port of the fourth transistor. The second circuit unit 913 can also be regarded as part of the aforementioned power supply circuit 807. The gate bias circuit 910 is electrically connected to the DC voltage input ports 915, 917 via bonding wires 914, 916 respectively. The DC voltage input ports 915, 917 can receive an external DC voltage.

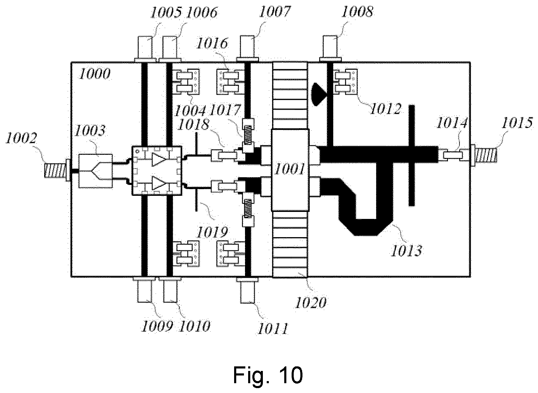

In other embodiments of the present disclosure, the power amplifier further comprises a second sub-package structure comprising the first transistor and the third transistor, and the power amplifier further comprises a carrier board for carrying the first sub-package structure and the second sub-package structure. As shown in Fig. 10, the power amplifier comprises a carrier board 1000, a first sub-package structure 1001, and a second sub-package structure 1021 arranged on the carrier board 1000. The first sub-package structure 1001 can be implemented in the form shown in Fig. 9, and the second sub-package structure comprising the first transistor and the third transistor described above. The carrier board 1000 can comprise a printed circuit board (PCB). The power amplifier shown in Fig. 10 is implemented as a Doherty amplifier. As shown in Fig. 10, the power amplifier further comprises a radio frequency signal input port 1002, a power divider 1003, a transmission line 1019, a heat sink 1020, an inductor 1017, a transmission line 1013, capacitors 1004, 1016, 1012, 1014, and a radio frequency signal output port 1015. The capacitor 1014 and the transmission line 1013 form an output combination network which combines the first amplifying signal generated by the first amplification path and the second amplifying signal generated by the second amplification path and outputs it from the radio frequency signal output port 1015. The power amplifier further comprises DC voltage inputs 1005, 1006, 1007, 1008, 1009, 1010, and 1011 transmitting corresponding DC voltages to the control ports (e.g., gates) and output ports (e.g., drains) of the first, second, third, and fourth transistors respectively.

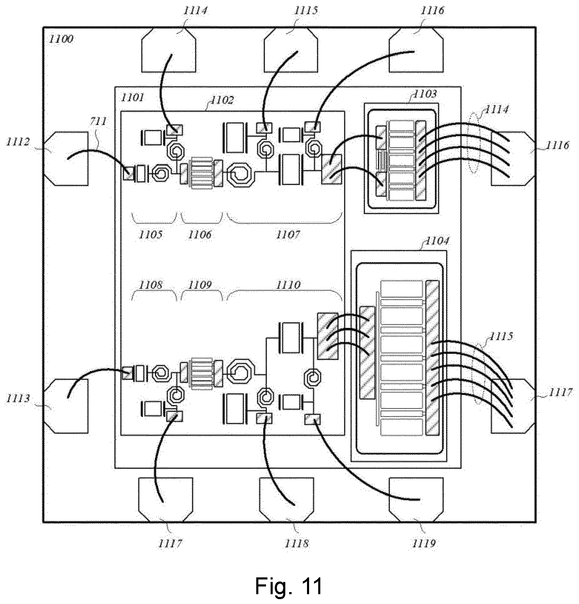

Fig. 11 shows a power amplifier provided according to another embodiment of the present disclosure, the power amplifier comprising a package structure 1100. As shown in Fig. 11, the package structure 1100 comprises a substrate 1101, a third sub-package structure 1102 located on the substrate 1101, a second transistor 1103 and a fourth transistor 1104, the third sub-package structure 1102 comprising a first transistor 1106 and a third transistor 1109, the second transistor 1103 and the fourth transistor 1104 being attached to the substrate 1101. That is, in the embodiment shown in Fig. 11, the package structure 1100 can be implemented in the form of one single chip, and the first transistor 1106 and the third transistor 1109 are integrated in a smaller chip (the third sub-package structure 1102), whereby the size of the power amplifier can be further reduced. The package structure shown in Fig. 11 clearly shows a first amplification path comprising an input matching network 1105, a first transistor 1106, a first inter-stage matching network 1107, a second transistor 1103, and a second amplification path comprising an input matching network 1108, a third transistor 1109, a second inter-stage matching network 1110, and a fourth transistor 1104. The input matching networks 1105, 1108, the first inter-stage matching network 1107, and the second inter-stage matching network 1107 comprise inductors, capacitors, and the like, and the circuit structure thereof can correspond to the schematic diagram of the input matching network and the inter-stage matching network in the power amplifier shown in Fig. 2, which will not be described here in detail. The structures of the input matching network 1105 and the input matching network 1108 are symmetrical to each other, and the structures of the first inter-stage matching network 1107 and the second inter-stage matching network 1110 are symmetrical to each other. The package structure shown in Fig. 11 comprises radio frequency signal input ports 1112, 1113, radio frequency signal output ports 1116, 1117, and DC voltage input ports 1114, 1115, 1116, 1117, 1118, 1119. The output ports of the second transistor and the output ports of the fourth transistor are connected to the radio frequency signal output ports 1116 and 1117 via bonding wires 1114 and 1115 respectively. In the embodiment of Fig. 11, the input matching networks 1105, 1108, the first inter-stage matching network 1107, and the second inter-stage matching network 1107 are also integrated in the third sub-package structure 1102, further improving the integration of the power amplifier.

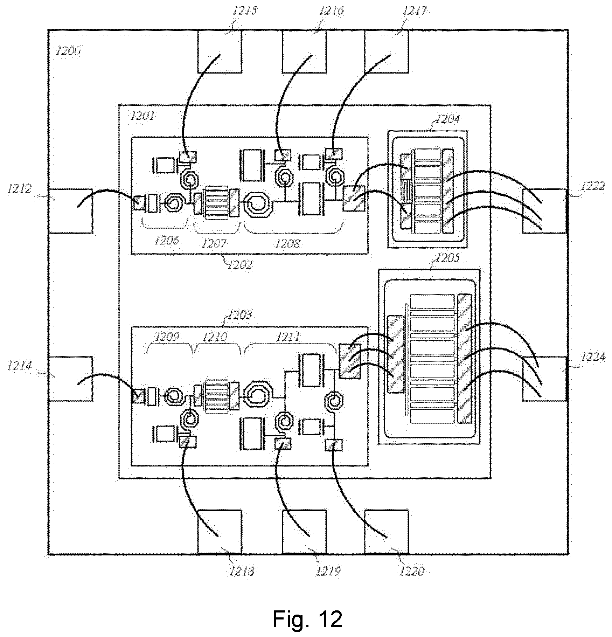

According to further embodiments of the present disclosure, the first inter-stage matching circuit and the first transistor can be integrated into one independent sub-package structure, and the second inter-stage matching circuit and the third transistor can be integrated into one independent sub-package structure. Fig. 12 is a schematic structural view of the power amplifier according to another embodiment of the present disclosure. The circuit topology of the power amplifier 1200 shown in Fig. 12 is similar to Fig. 11, except that the sub-package structure inside the package structure is different. As shown in Fig. 12, the first amplification path of the power amplifier comprises a first inter-stage matching circuit 1208 electrically connected between the first transistor 1207 and the second transistor 1204, and the second amplification path comprises a second inter-stage matching circuit 1211 electrically connected between the third transistor 1210 and the fourth transistor 1205. The power amplifier comprises a package structure 1200 comprising a substrate 1201, a fourth sub-package structure 1202 located on the substrate 1201, and a fifth sub-package structure 1203 located on the substrate 1201, the fourth sub-package structure 1202 comprising a first transistor 1207 and a first inter-stage matching circuit 1208, the fifth sub-package structure 1203 comprising a third transistor 1210 and a second inter-stage matching circuit 1211, the second transistor 1204 and the fourth transistor 1205 attached to the substrate 1201. As shown in Fig. 12, the fourth sub-package structure 1202 can further comprise an input matching circuit 1206, and the fifth sub-package structure 1203 can further comprise an input matching circuit 1209.

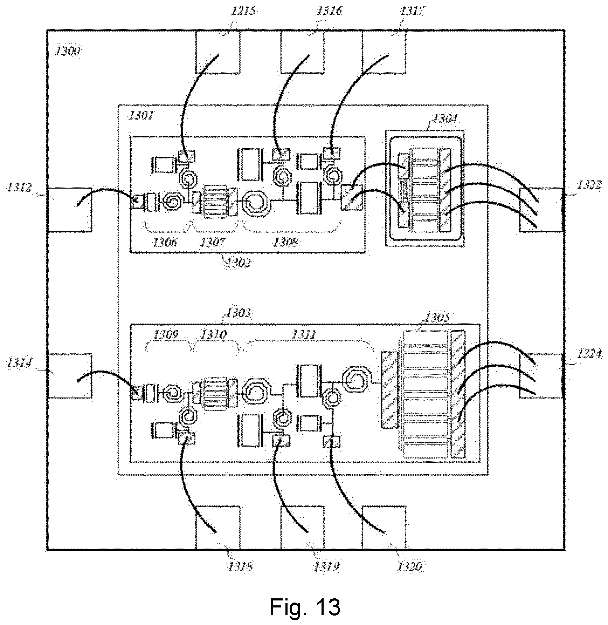

Fig. 13 is a schematic structural view of the power amplifier according to another embodiment of the present disclosure. As shown in Fig. 13, the power amplifier comprises a package structure 1300 comprising a substrate 1301, a sixth sub-package structure 1302 located on the substrate, a sixth sub-package structure 1302 comprising a first transistor 1307 and a first inter-stage matching circuit 1308, a seventh sub-package structure 1303 located on the substrate and comprising a third transistor 1310, a fourth transistor 1305, and a second inter-stage matching circuit 1311, and a second transistor 1304 being attached to the substrate 1301. The transistors, the first inter-stage matching circuit 1308, and the second inter-stage matching circuit 1311 shown in Fig. 13 are the same as shown in Fig. 12, except that the sub-package structure within the package structure 1300 is different. Further, the sixth sub-package structure 1302 and the seventh sub-package structure 1303 can also comprise input matching circuits 1306 and 1309 respectively. In the embodiment shown in Fig. 13, each of the first transistor 1307, the third transistor 1310, and the fourth transistor 1305 comprises a silicon transistor, and the second transistor 1304 can comprise a gallium nitride transistor. Since the third transistor 1310 and the fourth transistor 1305 are both silicon transistors, the seventh sub-package structure 1303 can be easily fabricated by a more cost-effective silicon-based process, and the second inter-stage matching circuit 1311 is fabricated in the seventh sub-package structure 1303, which further reduces the size of the power amplifier and is conducive to reducing the cost of fabricating the power amplifier.

It will be understood that, although the first, second, third and the like terms can be used herein to describe various devices, elements, components or portions, these devices, elements, components or portions should not be limited by these terms and only denote distinctions in terms of names. For example, the foregoing first to seventh sub-package structures are used only to distinguish names of sub-package structures in different embodiments of power amplifiers. In addition, references to "electrical connected" in this article comprise "direct connected" or "indirect connected". Although the technical proposals of the present disclosure have been described in connection with some embodiments, the scope of protection of the present disclosure is not limited to the particular forms set forth herein, the scope of the present disclosure being defined by the appended claims.

## Claims

1. A method of controlling a power amplifier, the power amplifier comprising:
a first amplification path comprising a first transistor and a second crystal, an output port of the first transistor being electrically connected to a control port of the second transistor; and
a second amplification path comprising a third transistor and a fourth transistor, an output port of the third transistor being electrically connected to a control port of the fourth transistor,
wherein the method comprises:
providing an input signal to the first amplification path and the second amplification path; and
supplying a first DC bias voltage and a second DC bias voltage to a control port of the third transistor and a control port of the fourth transistor respectively,
wherein current conduction trenches of the third transistor and the fourth transistor comprise same materials and the first DC bias voltage is higher than the second DC bias voltage.

2. The method according to claim 1, wherein each of the third transistor and the fourth transistor comprises a silicon transistor and the difference between the first DC bias voltage and the second DC bias voltage is not higher than 0.5 volts.

3. The method according to claim 2, wherein the difference between the first DC bias voltage and the second DC bias voltage is greater than or equal to 0.1 volts and less than or equal to 0.3 volts.

4. The method according to claim 3, wherein the first DC bias voltage is greater than or equal to 1.9 volts and less than or equal to 2.2 volts.

5. The method according to claim 1, wherein each of the third transistor and the fourth transistor comprises a silicon transistor and the second DC bias voltage is greater than 0 and less than or equal to 3 volts.

6. The method according to claim 5, wherein the second DC bias voltage is greater than or equal to 1.8 volts and less than or equal to 2.2 volts.

7. The method according to claim 1, wherein each of the first transistor, the third transistor, and the fourth transistor comprises a silicon transistor, and the second transistor comprises a gallium nitride transistor.

8. The method according to claim 1, wherein the step of providing input signals to the first amplification path and the second amplification path comprises:
allocating the input signal to the first amplification path and the second amplification path using the power divider.

9. The method according to claim 1, further comprising:
in response to a power of the input signal being greater than or equal to a power threshold, providing a third DC bias voltage and a fourth DC bias voltage to an output port of the third transistor and an output port of the fourth transistor respectively; and
in response to the power of the input signal being less than the power threshold, stopping supplying the third DC bias voltage and the fourth DC bias voltage to the output port of the third transistor and the output port of the fourth transistor.

10. A power amplifier comprising:
a first amplification path comprising a first transistor having an output port electrically connected to a control port of the second transistor and a second transistor, the first amplification path being configured to obtain a first amplifying signal based on an input signal;
a second amplification path comprising a third transistor and a fourth transistor, the third transistor having an output port electrically connected to a control port of the fourth transistor, and a current conduction trench of the third transistor and the fourth transistor comprising same materials, the second amplification path being configured to obtain a second amplifying signal based on the input signal; and
a first power supply circuit configured to provide a first DC bias voltage and a second DC bias voltage to a control port of the third transistor and a control port of the fourth transistor respectively, the first DC bias voltage being higher than the second DC bias voltage.

11. The power amplifier according to claim 10. wherein each of the first transistor, the third transistor, and the fourth transistor comprises a silicon transistor, and the second transistor comprises a gallium nitride transistor.

12. The power amplifier according to claim 11, wherein the power amplifier comprises a first sub-package structure comprising the second transistor and the fourth transistor.

13. The power amplifier according to claim 12, wherein the first sub-package structure further comprises the first power supply circuit.

14. The power amplifier according to claim 12, wherein the power amplifier further comprises a second sub-package structure comprising the first transistor and the third transistor, and the power amplifier further comprises a carrier board for carrying the first sub-package structure and the second sub-package structure.

15. The power amplifier according to claim 11, wherein the power amplifier comprises a package structure comprising:
a substrate; and
a third sub-package structure located on the substrate, the third sub-package structure comprising the first transistor and the third transistor,
wherein the second transistor and the fourth transistor are attached to the substrate.

16. The power amplifier according to claim 11, wherein the first amplification path further comprises a first inter-stage matching circuit electrically connected between the first transistor and the second transistor, the second amplification path further comprises a second inter-stage matching circuit electrically connected between the third transistor and the fourth transistor;
wherein the power amplifier comprises a package structure comprising:
a substrate;
a fourth sub-package structure located on the substrate; and
a fifth sub-package structure located on the substrate,
wherein the fourth sub-package structure comprises the first transistor and the first inter-stage matching circuit, and the fifth sub-package structure comprises the third transistor and the second inter-stage matching circuit, and the second transistor and the fourth transistor are attached to the substrate.

17. The power amplifier according to claim 11, wherein the first amplification path further comprises a first inter-stage matching circuit electrically connected between the first transistor and the second transistor, the second amplification path further comprises a second inter-stage matching circuit electrically connected between the third transistor and the fourth transistor,
wherein the power amplifier comprises a package structure comprising:
a substrate;
a sixth sub-package structure located on the substrate; and
a seventh sub-package structure located on the substrate,
wherein the sixth sub-package structure comprises the first transistor and the first inter-stage matching circuit, the seventh sub-package structure comprises the third transistor, the fourth transistor, and the second inter-stage matching circuit, and the second transistor is attached to the substrate.

18. The power amplifier according to any one of claims 10 to 17, wherein the power amplifier further comprises a second power supply circuit comprising:
a power detector configured to detect a power of the input signal;
a voltage regulation circuit configured to be electrically connected to the output port of the third transistor and the output port of the fourth transistor to provide a third DC bias voltage and a fourth DC bias voltage to the output port of the third transistor and the output port of the fourth transistor respectively; and
a controller electrically connected to the power detector and the voltage regulation circuit and configured to disable the voltage regulation circuit in response to the power of the input signal being less than the power threshold and enable the voltage regulation circuit in response to the power of the input signal being greater than or equal to the power threshold.
